# EUROPEAN PATENT APPLICATION

(11) **EP 2 916 067 A1**
(43) Date of publication of application: **09.09.2015**
(21) Application number: 13850315.6
(22) Date of filing: 22.10.2013
(51) Int. Cl.: F21V 31/03, F21S 8/10, F21V 15/01

(54) **VENTILATION MEMBER**

(30) Priority: 01.11.2012 JP 2012242218
(71) Applicant: Nitto Denko Corporation, Ibaraki-shi, Osaka 567-8680 (JP)
(72) Inventor: ISHII, Kyoko, Ibaraki-shi Osaka 567-8680 (JP); YANO, Youzou, Ibaraki-shi Osaka 567-8680 (JP)
(74) Representative: Intès, Didier Gérard André
(86) International application number: PCT/JP2013/006246
(87) International publication number: WO 2014/068902

(57) **Abstract**

A ventilation member 1 includes: a tubular inner member 2 adapted to be fitted to an opening portion 50a and having a through hole 2a whose opening is not equipped with a waterproof gas-permeable membrane and which serves as a part of a ventilation path 4 between a space inside a housing 50 and a space outside the housing 50; and a tubular outer member 3 having a bottom, fitted around the outer periphery of the inner member 2, and covering the opening of the through hole 2a. The inner member 2 and the outer member 3 are each formed of a hydrophobic material having a contact angle with water of 80 degrees or more.

## Description

### TECHNICAL FIELD

The present invention relates to a ventilation member to be attached to an opening of a housing.

### BACKGROUND ART

Conventionally, for example, in automobile electrical parts such as automobile lamps and ECUs (Electrical Control Units), OA (office automation) equipment, household electrical appliances, and medical devices, a housing containing an electrical part or a control board is provided with an opening for the purpose of reducing pressure variation in the housing caused by temperature change or allowing replacement of air in the housing, and a ventilation member is attached to the opening. The ventilation member ensures ventilation between the inside and outside of the housing, and also prevents foreign matters such as dust and water from entering the housing.

For example, Patent Literature 1 discloses a ventilation member 100 as shown in FIG. 6. This ventilation member 100 is composed of a tubular cover member 101 having a bottom, a tubular body 102 made of rubber, and a waterproof gas-permeable membrane 103. The tubular body 102 has a slightly smaller diameter than the cover member 101, and the waterproof gas-permeable membrane 103 is disposed so as to close one opening of the tubular body 102. The tubular body 102 is fitted into the cover member 101 by inserting the tubular body 102 into the cover member 101 from the waterproof gas-permeable membrane 103 side. Thus, a ventilation path 104 is formed between the inner peripheral surface of the cover member 101 and the outer peripheral surface of the tubular body 102 and between the bottom surface of the cover member 101 and the waterproof gas-permeable membrane 103. To attach the ventilation member 100 to a housing 150, an opening portion 150a formed in the housing 150 is inserted in the tubular body 102.

### CITATION LIST

### Patent Literature

Patent Literature 1: JP 4043674 B2

### SUMMARY OF INVENTION

### Technical Problem

For example, in the case of use in an electrical part of an automobile, the automobile may be washed with water. In such a case, the ventilation member 100 may be subjected to an intense pressure of water, and water may enter the ventilation path 104. When a situation arises where water enters the ventilation path 104 to make the passage of air impossible, there is a possibility that, despite the presence of the waterproof gas-permeable membrane 103, the water will be drawn into the space inside the housing 150 due to the pressure difference between the inside and outside of the housing 150.

In view of such circumstances, the present invention aims to provide a ventilation member more suitable for preventing the entry of water into the housing.

### Solution to Problem

That is, the present invention provides a ventilation member attachable to an opening portion of a housing, the ventilation member including:
a tubular inner member adapted to be fitted to the opening portion and having a through hole whose opening is not equipped with a waterproof gas-permeable membrane and which serves as a part of a ventilation path between a space inside the housing and a space outside the housing; and
a tubular outer member having a bottom, fitted around an outer periphery of the inner member, and covering the opening of the through hole. The inner member and the outer member are each formed of a material having a contact angle with water of 80 degrees or more.

### Advantageous Effects of Invention

In the ventilation member of the present invention, the inner member and the outer member are each formed of a material having a contact angle with water of 80 degrees or more; therefore, the ventilation member is less subject to the entry of water into the ventilation path, and is suitable for reliable prevention of the entry of water into the housing. In addition, with the ventilation member of the present invention, the entry of water into the housing can be prevented even when there is a slight gap between the ventilation member and the housing. Furthermore, the ventilation member of the present invention does not require any waterproof gas-permeable membrane, and is therefore suitable for achieving both waterproofing and ventilation with a simple structure. Therefore, the present invention is suitable also for providing a ventilation member that is cost-effective and has excellent properties.

### BRIEF DESCRIPTION OF DRAWINGS

FIG. 1 is an exploded perspective view of a ventilation member according to an embodiment of the present invention.
FIG. 2 is a cross-sectional view of the ventilation member shown in FIG. 1.
FIG. 3 is a schematic view showing a contact angle between water and the surface of the outer member shown in FIG. 1.
FIG. 4 is a schematic view showing a contact angle between water and the surface of the inner member shown in FIG. 1.
FIG. 5 is an enlarged cross-sectional view of the vicinity of an opening of a ventilation path of the ventilation member shown in FIG. 1.
FIG. 6 is a cross-sectional view of a conventional ventilation member.

### DESCRIPTION OF EMBODIMENTS

Hereinafter, an embodiment of the present invention will be described with reference to the accompanying drawings. The following description relates to an example of the present invention, and the present invention is not limited by this example.

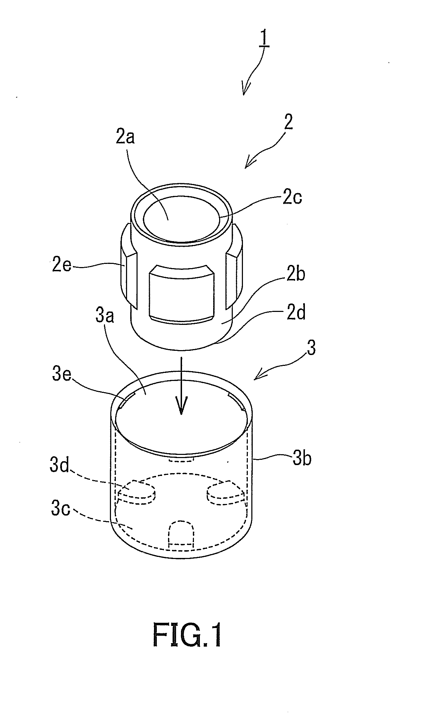

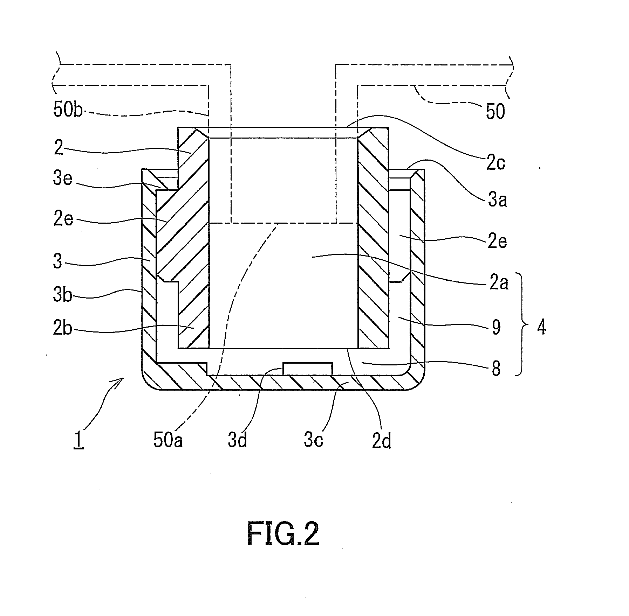

As shown in FIG. 1 and FIG. 2, a ventilation member 1 according to an embodiment of the present invention is one which is to be attached to an opening portion 50a of a housing 50. The opening portion 50a includes a through hole for allowing communication between a space inside the housing 50 and a space outside the housing 50, and is provided in a cylindrical neck portion 50b projecting from an outer surface of the housing 50. The ventilation member 1 includes: a tubular inner member 2 having a through hole 2a; and a tubular outer member 3 having a bottom, fitted around the outer periphery of the inner member 2, and covering the opening of the through hole 2a. In a state where the inner member 2 is fitted on the neck portion 50b, the through hole 2a serves as a part of a ventilation path 4 between the space inside the housing 50 and the space outside the housing 50. A waterproof gas-permeable membrane for the opening of the through hole 2a and the step of attaching the membrane are omitted; consequently, the ventilation member 1 can be provided at a lower cost. The inner member 2 and the outer member 3 are each formed of a hydrophobic material having a contact angle with water of 80 degrees or more. Therefore, the entry of water into the ventilation path 4 is prevented. The contact angle with water is an angle formed between a surface and a tangent line drawn from a point of contact of water droplet with the surface so as to be tangent to the curved outline of the water droplet, and is an index representing the wettability of the surface. For example, if the contact angle is small, the surface is highly wettable (hydrophilic), while if the contact angle is large, the surface is poorly wettable (hydrophobic). The contact angle can be measured by the method according to Japanese Industrial Standards (JIS) R 3257 (Testing method of wettability of glass substrate).

The inner member 2 is a tubular member which is made of a thermoplastic elastomer and whose surface has a contact angle with water of 80 degrees or more, preferably 90 degrees or more. The surface of the inner member 2 is not subjected to liquid-repellent treatment. In other words, no liquid-repellent film is formed on the surface of the inner member 2. The inner member 2 is formed entirely of a material having a contact angle with water of 80 degrees or more. The inner member 2 has: a tube portion 2b having a cylindrical shape and having the through hole 2a in its interior; and four projecting portions 2e formed in the central region of the outer peripheral surface of the tube portion 2b so as to project outwardly and to be arranged at regular intervals in the peripheral direction. The outer periphery of each projecting portion 2e provides a surface that comes into contact with the inner periphery of the outer member 3. The outer diameter of the inner member 2, as defined by the regions where the projecting portions 2e are formed, is slightly larger than the inner diameter of the outer member 3. When the outer member 3 is fitted to the inner member 2, the projecting portions 2e are elastically deformed so that the outer member 3 is fixed to the inner member 2.

The through hole 2a has: a first opening portion 2c to be fitted to the neck portion 50b; and a second opening portion 2d provided on the opposite side to the first opening portion 2c and not equipped with a waterproof gas-permeable membrane unlike conventional ones. The inner member 2 is fitted around the outer periphery of the neck portion 50b by attaching the inner member 2 to the neck portion 50b from the first opening portion 2c side, and the through hole 2a communicates with the space inside the housing 50. The through hole 2a of the inner member 2 communicates with the space outside the housing (external atmosphere) via the second opening portion 2d and via communication paths 8 and 9 between the exterior portions of the inner member 2 and the interior portions of the outer member 3. The communication path 8 is a clearance formed between the second opening portion 2d of the inner member 2 and the inner side of a bottom portion 3c of the outer member 3. The communication path 9 is a clearance formed between the inner periphery of the outer member 3 and those regions of the outer periphery of the inner member 2 in which the projecting portions 2e are not formed. As thus described, the ventilation member 1 has, between the inner member 2 and the outer member 3, the communication paths 8 and 9 which serve as a part of the ventilation path 4. The communication paths 8 and 9 communicate with the space outside the housing.

The ventilation path 4 is constituted by the through hole 2a of the inner member 2 and the communication paths 8 and 9. The ventilation path 4 is a continuous space that is not divided by a waterproof gas-permeable membrane. That is, not only the through hole 2a but also the communication paths 8 and 9 are not provided with any waterproof gas-permeable membrane. The prevention of entry of water through the ventilation path 4 is achieved not by the presence of a waterproof gas-permeable membrane but by the hydrophobicity of the surfaces of the inner member 2 and the outer member 3. The prevention of entry of water can be reliably achieved by narrowing at least a part of the ventilation path 4. In the ventilation member 1, the through hole 2a is designed to be narrower than the communication paths 8 and 9. For reliable prevention of entry of water, it is advantageous that the opening portion 3a facing the external atmosphere be small.

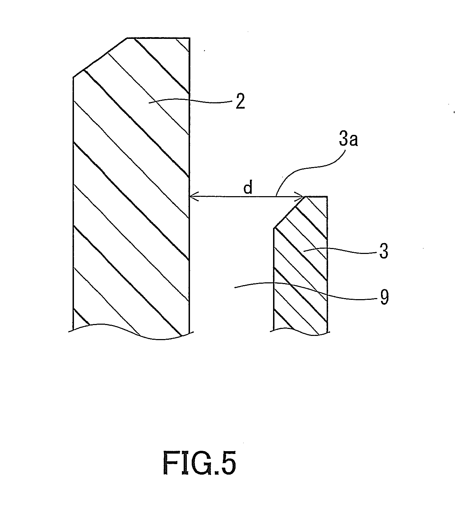

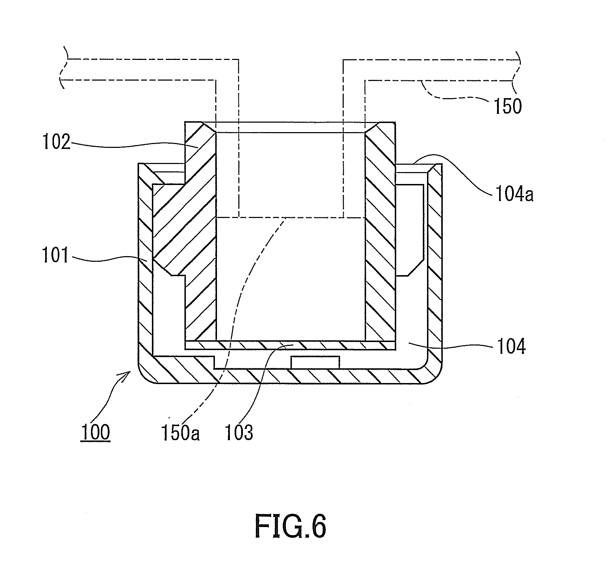

The opening portion 3a is a clearance that is formed between the outer periphery of the inner member 2 and the inner periphery of the outer member 3 and that is ring-shaped in plan view. The opening portion 3a communicates with the communication path 9, and is open to the external space. As shown in FIG. 5 in an enlarged manner, the distance d between the outer periphery of the inner member 2 and the inner periphery of the outer member 3 is preferably 1.75 mm or less and particularly preferably 1.0 mm or less as measured at the opening portion 3a. It should be noted that, as measured at the opening portion 104a of the conventional ventilation member 100 (see FIG. 6), the distance between the outer periphery of the tubular body 102 and the inner periphery of the cover member 101 is beyond 1.75 mm. This is because, in the conventional ventilation member 100, the waterproofness is ensured by the waterproof gas-permeable membrane 103.

The outer member 3 is a tubular member which has a bottom, which is made of PP (polypropylene), and whose surface has a contact angle with water of 80 degrees or more, preferably 90 degrees or more. The surface of the outer member 3 is not subjected to liquid-repellent treatment. In other words, no liquid-repellent film is formed on the surface of the outer member 3. The outer member 3 is formed entirely of a material having a contact angle with water of 80 degrees or more. The outer member 3 has: a tube portion 3b having the opening portion 3a and fitted around the outer periphery of the inner member 2; and the bottom portion 3c provided on the opposite side to the opening portion 3a and having an inner side facing the second opening portion 2d of the inner member 2. Three rest portions 3d are formed along the periphery of the inner side of the bottom portion 3c so as to be arranged at regular intervals in the peripheral direction. In addition, three engagement pieces 3e are formed along the inner periphery of the opening portion 3a so as to project inwardly and to be arranged at regular intervals.

In a state where the inner member 2 is fitted in the outer member 3, the outer peripheral surfaces of the projecting portions 2e are in contact with and press the inner peripheral surface of the outer member 3, and the upper surfaces of the projecting portions 2e are in engagement with the engagement pieces 3e. Furthermore, even if the inner member 2 is inserted up to the bottom surface of the outer member 3, the communication path 8 is secured between the bottom portion 3c of the outer member 3 and the second opening portion 2d of the inner member 2 in a state where the inner member 2 is fitted in the outer member 3, since the rest portions 3d formed on the bottom surface of the outer member 3 and the second opening portion 2d of the inner member 2 come into contact with each other.

The materials forming the inner member 2 and the outer member 3 are not limited to those mentioned above as examples (thermoplastic elastomer and PP), and may be any resin that has a contact angle with water of 80 degrees or more. The inner member 2 and the outer member 3 may be formed of the same material or may be formed of different materials, as long as the contact angle with water is 80 degrees or more. From the viewpoint of moldability and welding, thermoplastic resins, such as PET (polyethylene terephthalate), PPS (polyphenylene sulfide), PBT (polybutylene terephthalate), PC (polycarbonate), PP (polypropylene), and PPE (polyphenylene ether), are preferably used as the materials.

In the ventilation member 1 of the present embodiment, it is necessary that the inner member 2 and the outer member 3 be formed by selecting and using a hydrophobic material having a contact angle with water of 80 degrees or more. With the ventilation member 1 of the present embodiment, the entry of water through a gap between the ventilation member 1 and the housing 50 can also be prevented.

Hereinafter, the present invention will be described in more detail with reference to an example; however, the present invention is not limited to the example given below. In the example and comparative examples given below, ventilation members having the same structure as the ventilation member 1 shown in the drawings were fabricated.

First, the method of measuring the contact angles of the surfaces of the inner member 2 and the outer member 3 with water will be described.

### [Contact angle]

The contact angles (degrees) of the surfaces of the inner member 2 and the outer member 3 with water were measured according to JIS R 3257 (Testing method of wettability of glass substrate) by using a contact angle measuring device (Contact Angle System OCA 30 (manufactured by DataPhysics Instruments GmbH)) for prepared test samples each of which was a sheet (a square sheet having dimensions of 92 mm x 92 mm) made of the same resin as that used in the inner member 2 or the outer member 3.

### (Example 1)

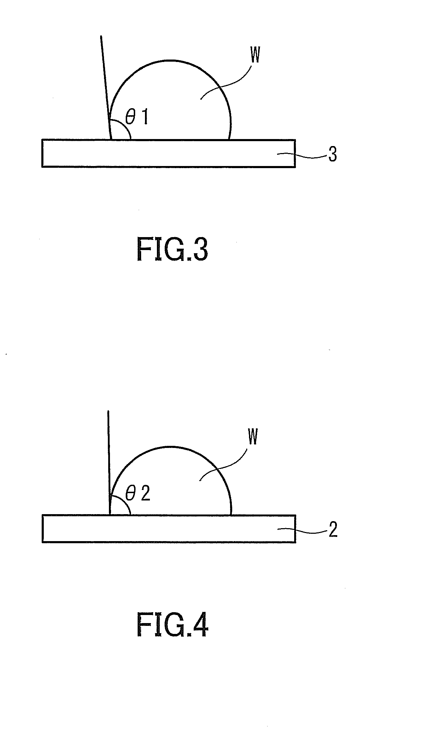

The inner member 2 and the outer member 3 were fabricated in such a manner that the outer diameter of the inner member 2 was 12.0 mm and the inner diameter of the outer member 3 was 15.5 mm, that is, in such a manner that the distance d between the outer periphery of the inner member 2 and the inner periphery of the outer member 3, as measured at the opening portion 3a, was 1.75 mm. A thermoplastic elastomer (EXCELINK 1100B manufactured by JSR Corporation) having a contact angle θ2 with water W of 91 degrees (see FIG. 4) was used as the material of the inner member 2. PP (polypropylene, PM 854X manufactured by SunAllomer Ltd.) having a contact angle θ1 with the water W of 96 degrees (see FIG. 3) was used as the material of the outer member 3. The ventilation member 1 was fitted onto the housing 50 as shown in FIG. 1, and a test was carried out in which water was consecutively applied dropwise from above. The entry of water into the housing 50 was not observed.

### (Comparative Example 1)

A test was carried out in the same manner as in Example 1, except for using an inner member 2 that was made of PA (polyamide, UBE Nylon 66 manufactured by Ube Industries, Ltd.) and whose surface had a contact angle with water of 77 degrees, and except for using an outer member 3 that was made of a paraffin (PARAFFIN WAX manufactured by GC Corporation) and whose surface had a contact angle with water of 10 degrees. Water entered the interior of the housing 50.

### (Comparative Example 2)

A test was carried out in the same manner as in Example 1, except for using an inner member 2 that was made of PA (polyamide, UBE Nylon 66 manufactured by Ube Industries, Ltd.) and whose surface had a contact angle with water of 77 degrees, and except for using an outer member 3 that was made of a phenolic resin (PHENOLITE manufactured by DIC Corporation) and whose surface had a contact angle with water of 60 degrees. Water entered the interior of the housing 50.

In Example 1, no waterproof gas-permeable membrane was attached to the opening of the through hole 2a of the inner member 2. Even without any waterproof gas-permeable membrane, the entry of water can be prevented by forming the inner member 2 and the outer member 3 of hydrophobic materials having a contact angle with water of 80 degrees or more.

### INDUSTRIAL APPLICABILITY

The waterproof ventilation member according to the present invention is suitable not only for use in housings of automobile electrical parts but also for use in housings, for example, of OA equipment, household electrical appliances, and medical devices.

## Claims

1. A ventilation member attachable to an opening portion of a housing, the ventilation member comprising:
a tubular inner member adapted to be fitted to the opening portion and having a through hole whose opening is not equipped with a waterproof gas-permeable membrane and which serves as a part of a ventilation path between a space inside the housing and a space outside the housing; and
a tubular outer member having a bottom, fitted around an outer periphery of the inner member, and covering the opening of the through hole,
wherein the inner member and the outer member are each formed of a material having a contact angle with water of 80 degrees or more.

2. The ventilation member according to claim 1, having a communication path that is formed between the inner member and the outer member and that serves as a part of the ventilation path,
wherein the communication path communicates with the space outside the housing.

3. The ventilation member according to claim 2, wherein a distance between the outer periphery of the inner member and an inner periphery of the outer member is 1.75 mm or less as measured at an opening of the communication path that is open to the space outside the housing.

4. The ventilation member according to claim 2, wherein the ventilation path is a continuous space that is not divided by a waterproof gas-permeable membrane.

5. The ventilation member according to claim 1, wherein the outer member is formed of a thermoplastic resin.

6. The ventilation member according to claim 1, wherein the inner member is formed of a thermoplastic elastomer.
